# EUROPÄISCHE PATENTSCHRIFT

(11) **EP 1 817 948 B1**
(45) Veröffentlichungstag und Bekanntmachung des Hinweises auf die Patenterteilung: **18.01.2012**
(21) Anmeldenummer: 05797064.2
(22) Anmeldetag: 11.10.2005
(51) Int. Cl.: H05K 5/06

(54) **ELEKTRISCHES GERÄT**
ELECTRIC DEVICE
APPAREIL ELECTRIQUE

(30) Priorität: 24.11.2004 DE 102004056662
(43) Veröffentlichungstag der Anmeldung: 15.08.2007
(73) Patentinhaber: ROBERT BOSCH GMBH, 70442 Stuttgart (DE)
(72) Erfinder: ZADACH, Peter, 72770 Reutlingen (DE); KUHN, Jochen, 72574 Bad Urach (DE)
(86) Internationale Anmeldenummer: PCT/EP2005/055161
(87) Internationale Veröffentlichungsnummer: WO 2006/056504

(56) Entgegenhaltungen:
- EP-A- 0 377 067
- EP-A- 0 961 534
- EP-A- 1 022 507
- DE-A1- 3 817 227
- DE-U- 1 790 076
- FR-A- 1 335 095
- FR-A- 2 854 023
- US-A- 3 987 258
- US-A- 5 497 290
- US-B1- 6 297 448

## Beschreibung

### Stand der Technik

Die Erfindung betrifft ein elektrisches Gerät mit einem Druckausgleichselement nach der Gattung des unabhängigen Patentanspruchs. Aus der deutschen Offenlegungsschrift DE 38 17 227 A1 ist ein elektrisches Gerät mit einem Druckausgleichselement bekannt, bei dem das Druckausgleichselement in eine Gehäuseöffnung eingesetzt ist. Nachteilig ist bei dieser Ausführung, dass einerseits das Druckausgleichselement aus vielen Einzelteilen aufgebaut ist und andererseits ein zusätzlicher Fügevorgang zur Befestigung des Druckausgleichelements im Gehäuse erforderlich ist.

### Vorteile der Erfindung

Das erfindungsgemäße elektrische Gerät mit den Merkmalen des Hauptanspruchs hat den Vorteil, dass durch die Ausbildung des Prallschutzes als einstückig mit dem Gehäuseteil verbundenes Teil sich insgesamt ein einerseits sehr wirkungsvolles und andererseits sehr einfach herzustellendes elektrisches Gerät mit einem Druckausgleichselement ergibt.

Erfindungsgemäß ist vorgesehen, dass der Prallschutz in einer Vertiefung angeordnet ist und sich über einem Boden der Vertiefung erstreckt bzw. erhebt. Durch diese Maßnahmen wird erreicht, dass es für auf das elektrische Gerät aufprallende Flüssigkeit, beispielsweise bei der Hochdruckreinigung mittels eines kompakten schnellen Flüssigkeitsstrahls, sehr schwer ist, diesen Flüssigkeitsstrahl einerseits auf den Prallschutz zu lenken und andererseits hohen Druck auf dort angeordnete Oberflächen auszuüben. Durch diese Maßnahme wird einerseits vermieden, dass überhaupt Flüssigkeit in den Bereich des Druckausgleichselements gelangt und andererseits Flüssigkeit mit einem hohen Impuls auf die Oberflächen trifft. Diese Maßnahme führt dazu, dass besonders wenig Flüssigkeit überhaupt bis an eine Membrane gelangt. Ferner ist der Prallschutz mittels einzelner Stützen am Boden der eben erwähnten Vertiefung befestigt. So besteht hier die Möglichkeit, Öffnungen zu lassen, durch die ein Luftaustausch mit dem Gehäuseinneren des elektrischen Geräts ermöglicht wird.

Durch die in den Unteransprüchen aufgeführten Maßnahmen sind vorteilhafte Weiterbildungen des elektrischen Geräts nach dem Hauptanspruch möglich. Bilden die Stützen an ihrer Außenseite eine kegelstumpfmantelförmige Hüllfläche, so erreicht man einerseits eben die bereits erwähnte, einem direkten Flüssigkeitsstrahl kaum aussetzbare Oberfläche und andererseits ermöglicht diese Gestaltung eine leichte Entformbarkeit dieser Kontur des Druckausgleichselements aus einem Spritzgusswerkzeug. Dieses Spritzgusswerkzeug wird für die Herstellung des Gehäuseteils mit der Kontur des Druckausgleichselements benötigt.

Dadurch, dass zwischen den Stützen Öffnungen angeordnet sind, die im Wesentlichen senkrecht zur nach außen gerichteten Oberfläche des Prallschutzes orientiert sind, lassen sich die Öffnungen von dem bereits erwähnten Flüssigkeitsstrahl kaum direkt treffen, so dass die sich darunter befindliche Membrane kaum bzw. gar nicht vom Flüssigkeitsstrahl getroffen wird. Dadurch wird einerseits ermöglicht, dass die Membrane zuverlässig an Ort und Stelle verbleiben kann, sich also unter dem Flüssigkeitsdruck nicht lösen kann. Wird auf einer zur Innenseite des Gehäuses gerichteten Rückseite des Bodens die vorzugsweise kreisförmige Membrane vorzugsweise durch ein stoffschlüssiges Fügeverfahren befestigt, so erreicht man, dass einerseits die Membrane besonders gut von außen geschützt ist und andererseits eine besonders große ringförmige Oberfläche auf der Rückseite des Bodens, die der Befestigung der Membrane dient. Die Membranfläche ist dadurch auch unabhängig von der Flächengröße der Öffnungen zwischen der Umgebung des elektrischen Geräts und der Membrane.

Erstreckt sich zwischen dem Boden und dem Prallschutz ein Ringsteg, so ermöglicht dies eine weitere Ablenkung eines möglicherweise in diesen Bereich, d.h. in die Vertiefung eindringenden Wasserschwalls, so dass weiter kinetische Energie des Wassers abgebaut wird. Der Druck auf die Membrane wird somit weiter abgebaut. Die Zuverlässigkeit und Haltbarkeit der Membrane bzw. der Membranbefestigung wird gesteigert.

Eine weitere verbesserte Möglichkeit zur Befestigung der Membrane besteht darin, auf der Rückseite des Prallschutzes einen Zapfen vorzusehen, der sich vom Boden ins Gehäuseinnere erstreckt. Der Zapfen endet vorzugsweise in der Ebene der bereits erwähnten Ringfläche auf der die Membrane befestigt ist, so dass die Membrane vorspannungsfrei zusätzlich auf einer Zylinderstirnfläche des Zapfens befestigt werden kann.

Nach einer weiteren Ausbildung der Erfindung ist vorgesehen, dass die Vertiefung, in der sich der Prallschutz befindet, durch einen Kegelstumpfring gebildet ist. Dies ermöglicht von beiden Seiten des Gehäuseteils eine einfache Entformung des beispielsweise durch Spritzgusstechnik hergestellten Gehäuseteils.

Desweiteren ist vorgesehen, dass der Kegelstumpfring über eine äußere Oberfläche des Gehäuseteils ragt. Es ergibt sich somit eine Art Ringwand, die bei über die Oberfläche des Gehäuseteils entlang strömender Flüssigkeit zumindest teilweise dafür sorgt, dass diese Flüssigkeit nicht in die Vertiefung strömt.

Es ist darüber hinaus vorgesehen, dass der über die Oberfläche des Gehäuseteils ragende Kegelstumpfring über eine im Wesentlichen trichterförmige äußere Oberfläche des Gehäuseteils ragt. Dies ermöglicht beispielsweise dann, wenn ein bestimmtes Quadermaß für das Steuergerät bzw. elektrische Gerät nicht überschritten werden soll, dennoch die Gestaltung der Oberfläche mittels dieses Rings, der dann so weit vorragt, dass dieser letztlich allerhöchstens mit der der trichterförmigen Oberfläche benachbarten - üblicherweise eine Fläche bildenden - Gehäuseoberfläche bündig abschließt.

Es ist vorgesehen, dass das Druckausgleichselement aus zwei Teilen, nämlich einer den Prallschutz tragenden Gehäuseschale und der Membrane selbst besteht. Aus diesen Anforderungen ergibt sich letztlich eine besonders montage- und herstellungsfreundliche und somit kostengünstige Fertigung eines Gehäuseteils mit Druckausgleichselement bzw. eines entsprechenden elektrischen Geräts.

Es ist vorgesehen, dass die das Eindringen von Flüssigkeit vermeidende Geometrie des Gehäuseteils aus zwei Formwerkzeugen herstellbar ist. Die Werkzeugkosten und somit die Herstellungskosten insgesamt werden dadurch reduziert.

Es ist desweiteren vorgesehen, dass die flüssigkeitsabweisende Geometrie bzw. Kontur ohne so genannte Querschieber in der Spritzgussform herstellbar ist.

### Zeichnungen

In den Zeichnungen sind ein Ausführungsbeispiel eines erfindungsgemäßen elektrischen Geräts mit einem Druckausgleichselement dargestellt. Es zeigen:
Figur 1 eine schematische Querschnittsdarstellung durch ein elektrisches Gerät mit einem Druckausgleichselement,
Figur 2 einen Querschnitt durch das Druckausgleichselement und das Gehäuseteil des elektrischen Geräts aus Figur 1,
Figur 3 eine geschnittene räumliche Darstellung des Druckausgleichselements aus Figur 2, wobei eine Ansicht von unten dargestellt ist,
Figur 4 einen Querschnitt durch zwei Teile eines bezüglich der Kontur des Druckausgleichselements querschieberfreien Spritzgusswerkzeuges mit einer darin befindlichen flüssigkeitsabweisenden Geometrie bzw. Kontur des Druckausgleichselements.

### Beschreibung

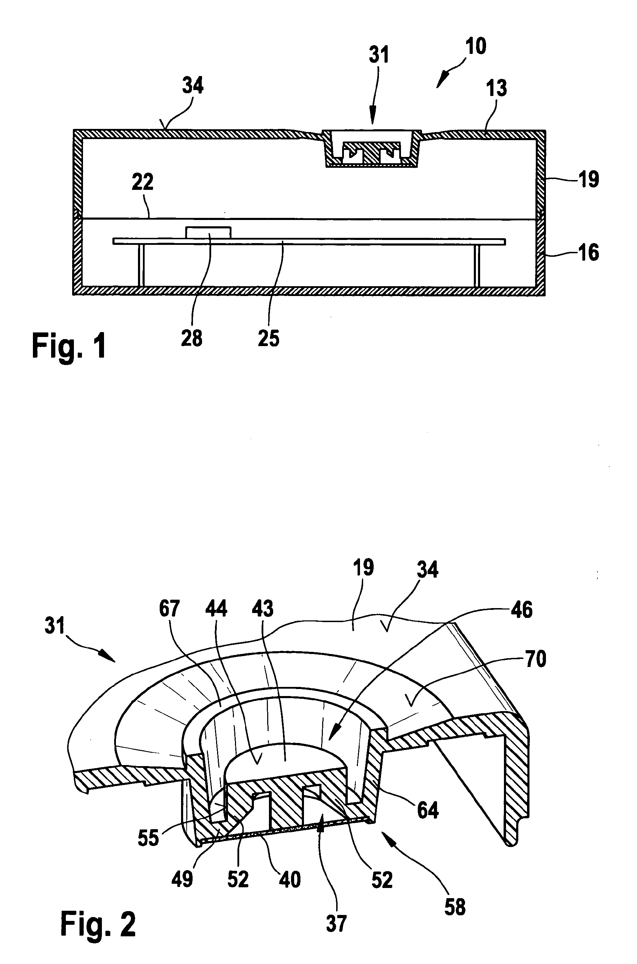

In Figur 1 ist ein Querschnitt durch ein elektrisches Gerät 10 dargestellt. Das elektrische Gerät 10 weist ein Gehäuse 13 auf, das aus einem unteren Gehäuseteil 16 und einem oberen Gehäuseteil 19 besteht. Beide Gehäuseteile 16 und 19 bilden zusammen das Gehäuse 13, das die Fuge 22 aufweist. Im Gehäuse 13 selbst ist eine Leiterplatte 25 angeordnet, auf der feuchtigkeitsempfindliche elektrische Baueinheiten, beispielsweise die elektrische Baueinheit 28, befestigt sind. Das obere Gehäuseteil 19 weist ein Druckausgleichselement 31 auf, das einen Gasaustausch durch eine Oberfläche 34 des Gehäuseteils 19 ermöglicht. Dieser Gasaustausch ist notwendig, um das Gehäuse 13 bei unterschiedlichen Außentemperaturen nicht allzu großen mechanischen Spannungen auszusetzen. Es soll damit vermieden werden, dass das Gehäuse undicht wird oder gar durch von außen oder innen wirkenden Luftdruck zerstört wird.

Figur 2 zeigt in räumlicher Ansicht einen Schnitt durch das bereits erwähnte Druckausgleichselement 31. Die Blickrichtung ist hier auf die äußere Oberfläche 34 des Gehäuses 13 gerichtet. Das Gehäuseteil 19 weist an seiner Oberfläche 34 das Druckausgleichselement 31 auf. Dieses Druckausgleichselement besteht aus mindestens einer Öffnung 37 und einer Membrane 40, die der Öffnung 37 in Richtung zum Gehäuseinneren nachgelagert ist. Damit ein von außen auf das Gehäuseteil 19 auftreffender Flüssigkeitsstrahl die Membrane 40 nicht unmittelbar durch die Öffnung oder Öffnungen 37 mit Druck beaufschlagen kann, ist ein Prallschutz 43 vorgesehen. Dieser Prallschutz 43 hat im Beispiel gemäß Figur 2 eine Oberfläche 44, die im Wesentlichen die gleiche Orientierung aufweist, wie die Oberfläche 34 des Gehäuseteils 19. Der Prallschutz 43 ist einstückig mit dem Gehäuseteil 19 ausgebildet und somit Teil des Gehäuseteils 19.

Es ist vorgesehen, dass die nach außen gerichtete Oberfläche des Prallschutzes 43 deutlich unterhalb der Oberfläche 34 des Gehäuseteils 19 endet.

Es ist somit ein elektrisches Gerät 10 mit einem Gehäuse 13 vorgesehen, wobei in dem Gehäuse 13 feuchtigkeitsempfindliche elektrische Baueinheiten 28 angeordnet sind, wobei in einem Gehäuseteil 13 ein Druckausgleichselement 31 angeordnet ist, das das Eindringen von Feuchtigkeit vermeidet bzw. verhindert. Das Druckausgleichselement 31 weist eine Membrane 40 auf, die gasdurchlässig ist sowie einen der Membrane 40 vorgelagerten Prallschutz 43, der ein direktes Bespritzen der Membrane 40 durch eine Flüssigkeit zumindest vermeidet. Es ist dabei vorgesehen, dass der Prallschutz 43 einstückig Teil des Gehäuseteils 13 ist.

Der Prallschutz 43 soll verhältnismäßig schlecht durch einen direkten Flüssigkeitsstrahl getroffen werden können, so dass vorgesehen ist, dass dieser Prallschutz 43 in einer Vertiefung 46 angeordnet ist. Diese Vertiefung 46 hat einen Boden 49, über dessen Niveau sich der Prallschutz 43 podestartig erhebt bzw. erstreckt. Der Prallschutz 43, an sich eine in etwa kreisförmige Platte mit der Oberfläche 44, ist damit mittels einzelner Stützen 52 am Boden 49 einstückig befestigt. Die Stützen 52 bilden dabei an ihrer Außenseite eine prismatische Hüllfläche 55, die vorzugsweise, so wie in Figur 2 dargestellt, eine - wegen der Öffnung oder Öffnungen 37 - gelochte Kegelstumpfmantelform aufweist. Ideal wäre, wenn diese Hüllfläche 55 zylindrisch ausgebildet wäre, was sich aber aufgrund von fertigungstechnischen Hindernissen (Entformung) in der Praxis nicht bewährt.

Die Vertiefung 46 begünstigt das Ablaufen von Flüssigkeit und Verschmutzung bei quer zur oder in Richtung der Erdbeschleunigung gerichteter Oberfläche 44 des Prallschutzes 43.

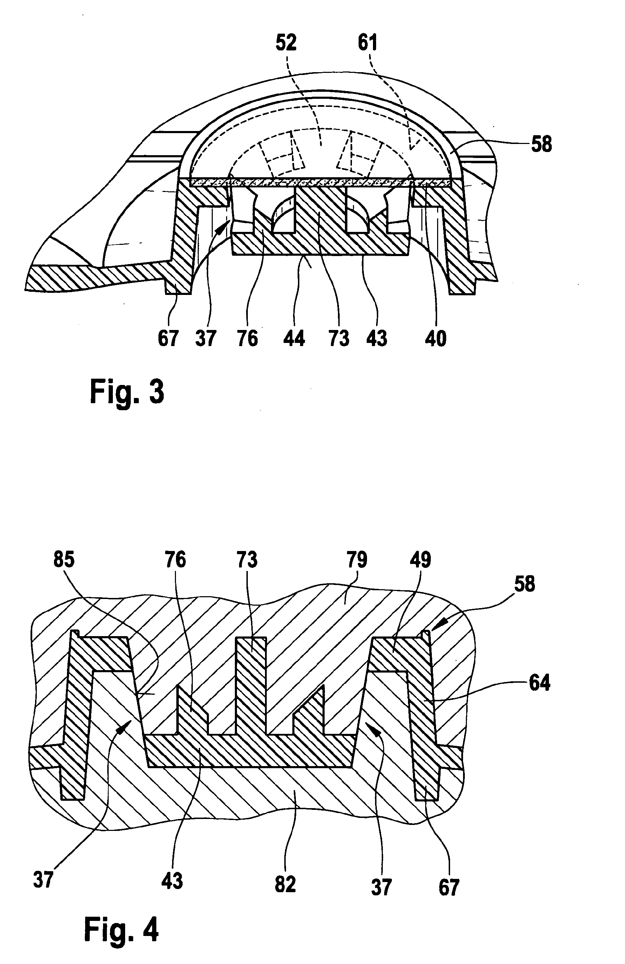

Des Weiteren ist vorgesehen, dass zwischen den Stützen 52 die Öffnungen 37 angeordnet sind. Diese Öffnungen 37 sind wegen der Orientierung der bereits erwähnten Hüllfläche 55 im Wesentlichen senkrecht zur nach außen gerichteten Oberfläche 44 des Prallschutzes 43 orientiert. Siehe hierzu auch Figur 3, in der die Öffnungen 37 besser erkennbar sind.

Vorzugsweise hat eine einzelne Öffnung 37 eine kompakte Flächengröße von ca. 4 mm² und größer, jedoch mindestens 3 mm². "Kompakte" Flächengröße bedeutet, das die Umrandung einer einzelnen Öffnung 37 möglichst kurz, also die Fläche der Öffnung 37 beispielsweise rund oder rechteckig, idealerweise quadratisch, ist. Gegenüberliegende Begrenzungskanten der Öffnung 37 sollen zumindest 2 mm beabstandet sein.

Auf der Rückseite des Bodens 49 erstreckt sich ins Innere des Gehäuses 13 ein Ringsteg 58, der zudem eine ringförmige Oberfläche 61, siehe hierzu Figur 3, begrenzt. Wie in Figur 2, aber auch Figur 3 erkennbar, bildet dieser Ringsteg 58 eine Grenze, innerhalb derer die im Ausführungsbeispiel kreisrunde Membrane 40 auf dem Ringsteg 61 befestigt wird bzw. ist.

Während vom Boden 49 nach radial innen und nach Außen die bereits erwähnten Stützen 52 ausgehen, geht vom Boden 49 radial äußeren Rand ein Kegelstumpfring 64 aus. Auch hier wäre ideal ein Zylinderring, aber auch hier gilt die gleiche Einschränkung wie bereits zur Hüllfläche 55 erwähnt. Der Kegelstumpfring 64 beginnt am Boden 49 und erstreckt sich in Richtung zur Oberfläche 34 des Gehäuseteils 19. Dieser Kegelstumpfring 64 bildet die topfartige Vertiefung 46. Der Kegelstumpfring 64 ragt hier über die äußere Oberfläche 34 des Gehäuseteils 19 und endet in einer Ringwand 67, die einen kragenartigen Schutz bzw. eine kragenartige Wand bildet und somit das Eindringen von Flüssigkeit in die Vertiefung 46 ansatzweise verhindert. Im Ausführungsbeispiel endet diese Ringwand 67 in einer trichterförmigen gegenüber der weiteren Oberfläche 34 abgesenkten Oberfläche 70, damit die Ringwand 67 über eine quaderförmige Oberfläche des Gehäuses 13 beispielsweise nicht hinausragt. Ohne den Quader zu überschreiten kann die Ringwand 67 dennoch über die Oberfläche 34 ragen. In Figur 3 ist erkennbar, wie die Membrane 40 auf der Ringfläche 61 aufliegt. Diese zur Innenseite des Gehäuses 13 gerichtete Rückseite des Bodens 49 trägt die vorzugsweise kreisförmige Membrane 40, die ebenso vorzugsweise durch ein stoffschlüssiges Fügeverfahren dort befestigt ist. Als stoffschlüssige Fügeverfahren kommen hier beispielsweise ein Schweißverfahren (Ultraschallschweißen) oder auch ein Klebeverfahren in Frage.

Zur besseren Abstützung der Membrane 40 kann diese zusätzlich durch einen Zapfen 73 gestützt sein. Dieser Zapfen 73 erstreckt sich auf der Rückseite des Bodens 49 in Richtung zum Gehäuseinneren und endet auf dem Niveau der Ringfläche 61. Die Membrane 40 kann hier ebenso durch ein stoffschlüssiges Fügeverfahren befestigt bzw. fixiert sein.

Wie in Figur 3 deutlich zu erkennen, erstreckt sich zwischen dem Boden 49 und dem Prallschutz 43 ein Ringsteg 76. Dieser Ringsteg 76 dient dazu, einem in Figur 3 von unten in die Vertiefung 46 hereinschwallenden Wasserstrahl als Teil eines Labyrinths zu dienen und somit kinetische Energie des Wasserstrahls abzubauen. Der Ringsteg 76 wirkt somit als eine Art Barriere und vermeidet somit eine allzu starke Benetzung der Membrane 40. Die Membrane 40 ist übrigens vorzugsweise aus Polytetrafluorethylen-(PTFE)-Folie.

Der Ringsteg 76 verhindert zumindest teilweise, dass von der Wand der Vertiefung 46 abprallendes Wasser bzw. Flüssigkeit direkt auf die Membran 40 treffen kann.

Wie leicht erkennbar, ist vorgesehen, dass das Druckausgleichselement 31 aus zwei Teilen, nämlich einem den Prallschutz 43 tragenden Gehäuseteil 19 und der Membrane 40 besteht. Es ist vorgesehen, dass eine flüssigkeitsabweisende Geometrie (Vertiefung 46, Bodenkegelstumpfring 64, Boden 49, Stützen 52, Öffnung 37, Prallschutz 43; ggf. zusätzlich der Zapfen 73, der Ringsteg 76, der Ringsteg 58, die Ringwand 67, die trichterförmige Oberfläche 70) aus zwei Formwerkzeugen herstellbar ist, siehe auch Figur 4. Die Formwerkzeuge sind im Bereich des Druckausgleichselements 31 ein oberes Formteil 79 ein unteres Formteil 82, die sich derartig ergänzen, dass zwischen sich die flüssigkeitsabweisende Geometrie querschieberfrei darstellbar ist. Die Öffnungen 37 liegen in einer Teilungsfläche 85, die durch die beiden Formwerkzeuge gebildet sind.

Es ist desweiteren vorgesehen, dass die flüssigkeitsabweisende Geometrie, siehe oben, ohne Querschieber im Spritzgusswerkzeug herstellbar ist, Figur 4.

Trifft beispielsweise ein Flüssigkeitsstrahl direkt in die Vertiefung 46, so wird ein Teil des Flüssigkeitsstrahls vom Prallschutz 43 abgelenkt. Ein Teil der Flüssigkeit, die bis zum Boden 49 strömt, wird in die Öffnung 37 gedrückt, dort jedoch durch einen eventuell vorhandenen Ringsteg 76 zumindest etwas gebremst. Durch diese labyrinthartige Gestalt des Flusswegs bis zur Membrane 40 steigt der Strömungswiderstand von der Oberfläche 34 bis zur Membrane 40. Dadurch ergibt sich zwangsläufig, dass letztlich die Membrane 40 erreichende Flüssigkeitsmenge geringer sein wird als üblich.

Die Funktion des Druckausgleichselements 31 ist wie folgt: Trifft ein Flüssigkeitsstrahl schräg auf das Gehäuseteil 19, so wird ein Teil dieses Strahls bereits durch die ggf. vorhandene Ringwand 67 abgelenkt und erreicht gar nicht erst die Vertiefung 46. Durch den ohnehin schrägen Aufprall des Flüssigkeitsstrahls ist ein direktes Auftreffen des Flüssigkeitsstrahls auf die Öffnungen 37 praktisch ausgeschlossen, da der Prallschutz 43 zu tief unterhalb der Oberfläche 34 sitzt. Der schräge Flüssigkeitsstrahl wird an der zum Prallschutz 43 gerichteten Oberfläche des Kegelstumpfrings 64 abgelenkt und abgebremst. Ein weiteres Abbremsen erfolgt dann wiederum mit der Umlenkung in die Öffnungen 37. Der eingetretene Strahlanteil wird hier dann durch den ggf. vorhandenen Ringsteg 76 ein weiteres Mal abgebremst. Die gasdurchlässige Membrane 40 wird auch hier somit nur äußerst gering durch die Flüssigkeit beaufschlagt.

## Patentansprüche

1. Elektrisches Gerät mit einem Gehäuse (13) und in dem Gehäuse (13) angeordneten feuchtigkeitsempfindlichen elektrischen Baueinheiten (28), mit einem in einem Gehäuseteil (19) angeordneten Druckausgleichselement (31), welches einen Gasaustausch durch eine Oberfläche (34) eines Gehäuseteils (19) ermöglicht, und das Eindringen von Feuchtigkeit vermeidet, vorzugsweise verhindert, wobei das Druckausgleichselement (31) eine Membrane (40) umfasst, die gasdurchlässig ist, mit einem der Membrane (40) vorgelagerten Prallschutz (43), der ein direktes Bespritzen der Membrane (40) durch eine Flüssigkeit zumindest vermeidet,
**dadurch gekennzeichnet, dass**
der Prallschutz (43) einstückig Teil des Gehäuseteils (13) ist, und dass der Prallschutz (43) in einer Vertiefung (46) angeordnet ist und sich über einem Boden (49) der Vertiefung (46) erstreckt bzw. erhebt, und dass der Prallschutz (43), eine, insbesondere etwa kreisförmige, Platte mit einer Oberfläche (44), die im Wesentlichen die gleiche Orientierung aufweist, wie die Oberfläche (34), mittels einzelner Stützen (52) am Boden (49) befestigt ist.

2. Elektrisches Gerät nach Anspruch 2, **dadurch gekennzeichnet, dass** die Stützen (52) an ihrer Außenseite eine prismatische Hüllfläche (55) bilden.

3. Elektrisches Gerät nach Anspruch 1 oder 2, **dadurch gekennzeichnet, dass** zwischen den Stützen (52) Öffnungen (37) angeordnet sind, die im Wesentlichen senkrecht zur nach außen gerichteten Oberfläche (44) des Prallschutzes (43) orientiert sind.

4. Elektrisches Gerät nach einem der Ansprüche 1 bis 4, **dadurch gekennzeichnet, dass** auf einer zur Innenseite des Gehäuses (13) gerichteten Rückseite des Bodens (49) die vorzugsweise kreisförmige Membrane (40) vorzugsweise durch ein stoffschlüssiges Fügeverfahren befestigt ist.

5. Elektrisches Gerät nach Anspruch 5, **dadurch gekennzeichnet, dass** sich zwischen dem Boden (49) und dem Prallschutz (43) ein Ringsteg (76) erstreckt.

6. Elektrisches Gerät nach Anspruch 5 oder 6, **dadurch gekennzeichnet, dass** sich auf der Rückseite des Bodens (49) ein Zapfen (73) ins Gehäuseinnere erstreckt, auf dem die sich über den Zapfen (43) erstreckende Membrane (40) stoffschlüssig befestigt ist.

7. Elektrisches Gerät nach einem der Ansprüche 1 bis 7, **dadurch gekennzeichnet, dass** die Vertiefung (46) durch einen Kegelstumpfring (64) gebildet ist.

8. Elektrisches Gerät nach Anspruch 8, **dadurch gekennzeichnet, dass** der Kegelstumpfring (64) über eine äußere Oberfläche (34) des Gehäuseteils (19) ragt.

9. Elektrisches Gerät nach Anspruch 9, **dadurch gekennzeichnet, dass** die Oberfläche (34) des Gehäuseteils (13) dort trichterförmig ist.

10. Elektrisches Gerät nach einem der vorstehenden Ansprüche, **dadurch gekennzeichnet, dass** das Druckausgleichselement (31) aus zwei Teilen, nämlich dem den Prallschutz (43) tragenden Gehäuseteil (19) und der Membrane (40) besteht.

11. Elektrisches Gerät nach einem der vorstehenden Ansprüche, **dadurch gekennzeichnet, dass** die flüssigkeitsabweisende Geometrie aus zwei Formwerkzeugen herstellbar ist.

12. Elektrisches Gerät nach einem der vorstehenden Ansprüche, **dadurch gekennzeichnet, dass** die flüssigkeitsabweisende Geometrie ohne Querschieber herstellbar ist.

## Claims

1. Electrical device having a housing (13) and moisture-sensitive electrical units (28) which are arranged in the housing (13), having a pressure-compensation element (31) which is arranged in a housing part (19) and which allows gas to be exchanged through a surface (34) of a housing part (19) and prevents, preferably prohibits, the ingress of moisture, with the pressure-compensation element (31) comprising a diaphragm (40) which is gas-permeable, having an impact-protection means (43) which is positioned in front of the diaphragm (40) and at least prevents a liquid from splashing directly onto the diaphragm (40),
**characterized in that**
the impact-protection means (43) is an integral part of the housing part (19), and **in that** the impact-protection means (43) is arranged in a recess (46) and extends or rises above a base (49) of the recess (46), and **in that** the impact-protection means (43), an, in particular approximately circular, plate with a surface (44) which has substantially the same orientation as the surface (34), is attached to the base (49) by means of individual brackets (52).

2. Electrical device according to Claim 1, **characterized in that** the brackets (52) form, on their outside, a prismatic enveloping surface (55).

3. Electrical device according to Claim 1 or 2, **characterized in that** openings (37) are arranged between the brackets (52), the said openings being oriented substantially perpendicular to the outwardly directed surface (44) of the impact-protection means (43).

4. Electrical device according to one of Claims 1 to 3, **characterized in that** the preferably circular diaphragm (40) is attached to a rear face of the base (49), the said rear face being directed towards the inside of the housing (13), preferably by a cohesive joining process.

5. Electrical device according to Claim 4, **characterized in that** an annular web (76) extends between the base (49) and the impact-protection means (43) .

6. Electrical device according to Claim 4 or 5, **characterized in that** a pin (73) extends into the interior of the housing from the rear face of the base (49), the diaphragm (40) which extends over the pin (43) being cohesively attached to the said pin (73).

7. Electrical device according to one of Claims 1 to 6, **characterized in that** the recess (46) is formed by a frustoconical ring (64).

8. Electrical device according to Claim 7, **characterized in that** the frustoconical ring (64) projects beyond an outer surface (34) of the housing part (19).

9. Electrical device according to Claim 8, **characterized in that** the surface (34) of the housing part (19) is in the form of a funnel at that point.

10. Electrical device according to one of the preceding claims, **characterized in that** the pressure-compensation element (31) consists of two parts, specifically the housing part (19), which is fitted with the impact-protection means (43), and the diaphragm (40).

11. Electrical device according to one of the preceding claims, **characterized in that** the liquid-repellent geometry can be produced from two moulds.

12. Electrical device according to one of the preceding claims, **characterized in that** the liquid-repellent geometry can be produced without lateral slides.

## Revendications

1. Appareil électrique comprenant un boîtier (13) et des unités constructives électriques (28) sensibles à l'humidité disposées dans le boîtier (13), avec un élément d'équilibrage de la pression (31) disposé dans une partie de boîtier (19), qui permet un échange de gaz par une surface (34) d'une partie de boîtier (19), et qui réduit la pénétration d'humidité, de préférence l'empêche, l'élément d'équilibrage de la pression (31) comprenant une membrane (40) perméable aux gaz, avec une protection contre les impacts (43) montée avant la membrane (40), qui réduit au moins une pulvérisation directe de la membrane (40) par un liquide,
**caractérisé en ce que**
la protection contre les impacts (43) fait partie intégrante de la partie de boîtier (19) et **en ce que** la protection contre les impacts (43) est disposée dans un renfoncement (46) et s'étend ou s'élève au-dessus d'un fond (49) du renfoncement (46), et **en ce que** la protection contre les impacts (43), c'est-à-dire une plaque en particulier approximativement circulaire avec une surface (44) qui présente sensiblement la même orientation que la surface (34), est fixée au fond (49) au moyen de supports individuels (52).

2. Appareil électrique selon la revendication 1, **caractérisé en ce que** les supports (52) forment sur leur côté extérieur une surface d'enveloppe (55) prismatique.

3. Appareil électrique selon la revendication 1 ou 2, **caractérisé en ce que** des ouvertures (37) sont disposées entre les supports (52), lesquelles sont orientées sensiblement perpendiculairement vers la surface (44) orientée vers l'extérieur de la protection contre les impacts (43).

4. Appareil électrique selon l'une quelconque des revendications 1 à 3, **caractérisé en ce que** sur un côté arrière du fond (49) orienté vers le côté intérieur du boîtier (13), la membrane de préférence circulaire (40) est fixée de préférence par un procédé d'assemblage par liaison de matière.

5. Appareil électrique selon la revendication 4, **caractérisé en ce qu'**une nervure annulaire (76) s'étend entre le fond (49) et la protection contre les impacts (43).

6. Appareil électrique selon la revendication 4 ou 5, **caractérisé en ce qu'**un tourillon (73) s'étend à l'intérieur du boîtier du côté arrière du fond (49), sur lequel tourillon est fixée par liaison de matière la membrane (40) s'étendant par-dessus le tourillon (73).

7. Appareil électrique selon l'une quelconque des revendications 1 à 6, **caractérisé en ce que** le renfoncement (46) est formé par une bague tronconique (64).

8. Appareil électrique selon la revendication 7, **caractérisé en ce que** la bague tronconique (64) dépasse au-delà d'une surface extérieure (34) de la partie de boîtier (19).

9. Appareil électrique selon la revendication 8, **caractérisé en ce que** la surface (34) de la partie de boîtier (19) est en forme d'entonnoir à cet endroit.

10. Appareil électrique selon l'une quelconque des revendications précédentes, **caractérisé en ce que** l'élément d'équilibrage de la pression (31) se compose de deux parties, à savoir de la partie de boîtier (19) portant la protection contre les impacts (43) et de la membrane (40).

11. Appareil électrique selon l'une quelconque des revendications précédentes, **caractérisé en ce que** la géométrie repoussant les liquides peut être réalisée à partir de deux outils de formage.

12. Appareil électrique selon l'une quelconque des revendications précédentes, **caractérisé en ce que** la géométrie repoussant les liquides peut être fabriquée sans poussoir transversal.
